# EUROPÄISCHE PATENTSCHRIFT

(11) **EP 0 360 305 B1**
(45) Veröffentlichungstag und Bekanntmachung des Hinweises auf die Patenterteilung: **27.07.1994**
(21) Anmeldenummer: 89121410.8
(22) Anmeldetag: 03.12.1986
(51) Int. Cl.: C23C 16/44, C23C 16/34, C04B 35/58, C09K 3/14

(54) **Verfahren zur Herstellung von Verbundmaterialteilchen und deren Verwendung**
Process for producing particles of a composite material, and their use
Procédé de production de particules de matière composée et leur utilisation

(30) Priorität: 24.12.1985 DE 3546113
(43) Veröffentlichungstag der Anmeldung: 28.03.1990
(62) Teilanmeldung aus: 86116802.9
(73) Patentinhaber: SUMITOMO ELECTRIC INDUSTRIES, LTD., Osaka-shi, Osaka 541 (JP)
(72) Erfinder: Lux, Benno, Prof. Dr., CH-7550 Scuol/GR (CH)
(74) Vertreter: Weber, Dieter, Dr.

(56) Entgegenhaltungen:
- EP-A- 0 117 542
- DE-A- 3 522 583
- US-A- 4 415 420
- PATENT ABSTRACTS OF JAPAN, unexamined applications, C Sektion, Band 9, Nr. 267,24. Oktober 1985 THE PATENT OFFICE JAPANESE GOVERNMENT Seite 123 C 310
- PATENT ABSTRACTS OF JAPAN, unexamined applications, C Sektion, Band 9, Nr. 317,12. Dezember 1985 THE PATENT OFFICE JAPANESE GOVERNMENT Seite 2 C 319
- PATENT ABSTRACTS OF JAPAN, unexamined applications, C Sektion, Band 8, Nr. 187,28. August 1984 THE PATENT OFFICE JAPANESE GOVERNMENT Seite 39 C 240

## Beschreibung

Die Erfindung bezieht sich auf Verbundmaterialteilchen, bestehend aus einem inneren Kern, der von einer daran anhaftenden Schale umhüllt wird, sowie auf ein Verfahren zur Herstellung dieser Verbundmaterialteilchen.

Mehrphasige Verbundmaterialteilchen sind seit langem bekannt. Zum Beispiel sind Graphitpartikel mit dünnen Kupfer- oder Nickelschichten umhüllt sowie Umhüllung von Diamantpulvern mit z. B. dünnen Nickel- oder Kupferschichten oder Uranoxidteilchen mit Pyrokohlenstoff oder SiC-Schichten umhüllt in der Literatur beschrieben.

Der Vorteil derartiger Verbundpulver ist, daß sie, entweder als Pulver verwendet, besondere Oberflächeneigenschaften aufweisen, die vom Kernmaterial verschieden sind, oder durch Verpressen und Sintern zu mehrphasigen Körrern verarbeitet werden können, die besondere Eigenschaften haben.

Verfahren, derartige Pulver herzustellen, sind zum Beispiel chemische oder elektrolytische Abscheidung aus wäßriger Lösung bzw. Salzschmelzen oder Abscheidungen aus der Gasphase.

Auch epitaxisch abgeschiedene Diamantschichten auf Diamantpulvern wurden vor einiger Zeit beschrieben mit dem Ziel, das Gewicht des Diamantpulvers zu erhöhen. Besondere Änderungen der Physikalischen und chemischen Eigenschaften des Diamantpulvers wurden dabei nicht beabsichtigt (S. P. Chauhan, J. C. Angus, N. C. Gardner: J. of Appl. Phys. 47, 1976, Seiten 4746 bis 4754).

Für die Herstellung von Diamant-Schichten sind in der Literatur neue Verfahren zur Abscheidung von Diamant im metastabilen Bereich, im Unterdruck, beschrieben worden (K. Recker: Z. Dt. Gemmol. Ges. Nr. 1/2, 1984, 5/34).

Auch die Herstellung von superhartem BN wird in der Literatur mit analogen Methoden erwähnt (S. Komatsu, K. Akashi, T. Yoshida, Paper number P-5-11, Proceedings of the JSPC-7 Eindhoven, July 1985).

Die der Erfindung zugrundeliegende Aufgabe bestand nun darin, ein Verfahren zur Herstellung von Verbundmaterialteilchen mit verbesserten Eigenschaften zu bekommen.

Diese Aufgabe wird mit einem Verfahren mit den Merkmalen des Anspruches 1 gelöst. Zweckmäßig werden die so hergestellten Verbundmaterialteilchen zur Herstellung von Sinterkörpern verwendet.

Nach einer bevorzugten Ausführungsform besteht die Schale wenigstens teilweise aus einem superharten Stoff, der chemisch verschieden von dem Material des Kernes ist.

Unter superharten Stoffen werden Stoffe mit einer Härte von mehr als 3500 Vickers, bevorzugt mehr als 4500, besonders mehr als 6000, verstanden, die vorzugsweise Modifikationen von Kohlenstoff, Bornitrid und anderen Phasen aus dem ternären System B, N, C, darstellen, wobei diese Elemente als Hauptbestandteile auftreten. Einige in diesen Systemen auftretende Phasen oder Verbindungen können einzeln oder als Gemische oder als Übergangsstrukturen oder in der Form von Kristallgittern mit interstitiell eingelagerten Atomen oder als Mischkristalle oder als Kristallstrukturen, die mit einem hohen Anteil von Gitterfehlern behaftet sind, diese Härte erreichen.

Weiterhin ist es zweckmäßig, daß der innere Kern ein ein- oder polykristallines Teilchen aus einer superharten Modifikation von Bornitrid oder ein bei Temperaturen bis 1000 °C mit Kohlenstoff und/oder Bornitrid nicht oder höchstens wenig reagierender und sie bis zu dieser Temperatur nicht oder höchstens langsam auflösender Hartstoff, bestehend aus einem Karbid, z. B. SiC, B₄C, WC, TiC, TaC, einem Nitrid, z. B. TiN, TaN, ZrN, AlN, Si₃N₄, einem Borid, z. B. TiB₂, TaB₂, WB, einem Phosphid, z. B. BP, einem Sulfid, z. B. CaS, CeS, einem Silicid, z. B. MoSi₂, TiSi₂, einem Oxid, Oxynitrid, Oxycarbid, Oxycarbonitrid, z. B. Al₂O₃, AlNO, AlCON, Ti(C,O), Zr(C,N,O), einer NOSC (= Non-Oxide-Silicon-Ceramic), SiAlON, oder einem anorganischen Stoff normaler Härte, der bei Temperaturen bis 1000 °C mit Kohlenstoff und/oder BN nicht oder nur langsam reagiert oder diesen nicht oder nur wenig auflöst, z. B. Metalle wie Cu, Ag, Au, Legierungen, intermetallische Phase(n), Verbindungen wie Oxide und Oxidgemische, wie Silicate, Aluminate, Spinelle, oder Sulfide, Karbide, Nitride, Carbonitride, Oxykarbide, Silicide, Boride, Oxycarbonitride, Hydride, Aluminide, Ferrite, oder anorganische Salze, sowie mehrphasigen Mischungen dieser Stoffe bzw. Mischkristallen dieser Stoffe, oder einem festen Reaktionsprodukt, das im Reaktionssystem spontan auftritt und als heterogener Kristallkeim wirkt, ist.

Bei noch einer anderen bevorzugten Ausführungsform besteht die äußere Schale aus mehreren Schichten, wovon mindestens eine aus ein- oder polykristallinem Diamant und/oder einer anderen superharten Kohlenstoffmodifikation oder einer superharten Modifikation von Bornitrid oder einer superharten binären oder ternären Phase aus diesem System B,N,C besteht, wobei dieser superharte Stoffe eine zusammenhängende anhaftende Schicht bildet.

Weiterhin ist es zweckmäßig, wenn sowohl der Kern als auch die Schale aus Diamant und/oder einer anderen superharten Kohlenstoffmodifikation und/oder einer superharten BN-Modifikation besteht, wobei diese sich chemisch und/oder physikalisch in ihrer Struktur und/oder ihren Eigenschaften unterscheiden.

Zweckmäßig kann es auch sein, daß der Kern- so klein ist, daß er als ein homogener oder heterogener Keim für die Kristallisation des Superhartstoffes aus der damit übersättigten Gasphase anzusehen ist.

Im Gegensatz zu bereits in der Literatur beschriebenen Verbundpulverkörpern, die den superharten Bestandteil immer nur im Zentrum enthalten, ist es aufgrund der Erfindung jetzt möglich, superharte Stoffe auch dann als dünne Schicht in der äußeren Schale eines Pulververbundkörpers anzubringen, wenn der Kern nicht aus Diamant besteht. Mit gewissen, später näher beschriebenen Einschränkungen kann der Kern aus einer großen Reihe von Stoffgruppen frei ausgewählt werden. Der Kern kann auch aus einem superharten Stoff bestehen, der sich dann aber von den äußeren superharten Schichten der Umhüllung in seiner chemischen Zusammensetzung und/oder in seinen physikalischen und/oder chemischen Eigenschaften mehr oder weniger stark unterscheidet.

Eine Reihe von Kombinationsmöglichkeiten für fast vollständig aus superharten Stoffen bestehende Pulver existiert.

### 1. Kombination: Einkristalliner superharter Kern mit einkristalliner superharter Umhüllung mit vom Kern verschiedenen chemischen und/oder physikalischen Eigenschaften.

Obwohl die der Erfindung zugrundegelegte Umhüllung mit einem superharten Stoff normalerweise nicht einkristallin ist, kann dies erzwungen werden, und zwar insbesondere dann, wenn auch der Kern aus einem einkristallinen Teilchen besteht und die Schicht auf diesem Kern epitaxisches Wachstum zeigt. Das Wachstum dieser Umhüllungsschicht ist dann aber nicht gleichmäßig. Ihre Dicke ist von den Kernkristallflächen abhängig und je nach Unterlagsflächen unterschiedlich. Das heißt, gewisse Kristallflächen und Kristallorientierungen werden dicker belegt werden und andere dünner. Hochindizierte Flächen werden normalerweise stärker belegt. Kristallgleichgewichtsformen mit niedrig indizierten Flächen treten dadurch bevorzugt im äußeren Erscheinungsbild auf und können die äußere Gestalt (Habitus) der Pulverteilchen stark bestimmen.

### 2. Kombination: Superharter Kern und chemische gleichartige aber polykristalline, superharte Umhüllung.

Beispielsweise ist die Herstellung von superharten Bornitridschichten mit speziellen physikalischen Eigenschaften auf einem ein- oder polykristallinen superharten Bornitridkern möglich. Derartige Verbundpulver sind nicht nur für die weitere Verarbeitung zu einem Sinterprodukt von Interesse, sondern auch als Pulver selbst verwendbar.

Das Verfahren erlaubt aber auch, ohne hohen Druck durch eine Gasphasenreaktion als Umhüllung Diamant auf superharten Bornitridkernen herzustellen.

Ebenfalls ist es möglich, bei einem einkristallinen Kern anstelle der einkristallinen Schale eine polykristalline Schicht herzustellen, die z. B., als Pulver verwendet, beim Schleifen oder Polieren besonders griffig bleibt. Dabei kann eine teilweise epitaxische Beziehung zwischen dem Kern und der aufgewachsenen Schicht bestehen.

Die Schale wird sich aber im allgemeinen vom Kern auch bei Verwendung der gleichen chemischen Substanz (BN oder Kohlenstoff) unterscheiden, z. B. in ihrer chemischen Zusammensetzung, in ihren physikalischen Eigenschaften, in ihrem inneren Aufbau, z. B. der Zahl und Art der Einschlüsse von Kristallfehlern und deren Dimension. Im Falle des Bestehens des Kerns und der Schale aus dem gleichen superharten Material kann zwar oft kein Unterschied in der Kristallstruktur vorliegen, aber trotzdem können absichtlich zur Erzielung gewisser besonderer Eigenschaften die chemische Zusammensetzung und/oder die physikalischen und/oder chemischen Eigenschaften der Schale stark geändert werden. Dies kann in extremen Fällen sogar zur Änderung der Kristallstruktur (z. B. Diamant geht in Lonsdaleit über) führen, was aber nur in Ausnahmefällen der Fall sein wird und keineswegs zur Erzielung der gewünschten Eigenschaftsveränderungen notwendig ist.

Wenn die Schale sich vom superharten Kern nur in den chemischen und/oder physikalischen Eigenschaften, jedoch nicht in seiner Kristallstruktur vom Kern unterscheidet, z. B. im Falle eines Diamantkerns und einer Diamantschale oder einer Schale aus einer anderen superharten Kohlenstoffmodifikation, können durch eine Änderung der Zusammensetzung oder der physikalischen Struktur der äußeren Schale besondere Eigenschaften des so erzeugten Diamantpulvers erzielt werden. Nicht die Gewichtszunahme des Diamanten durch den Materialzuwachs ist dabei - im Gegensatz zu ähnlichen, in der Literatur bereits beschriebenen Verfahren - bedeutend, sondern die Vorteile, die diese neuen Eigenschaften erbringen.

Es ist so möglich, entweder durch chemische Zusätze (Doping) Änderung sowohl der physikalischen als auch der chemischen Natur in die äußere Schale einzuführen, oder während der Bildung dieser superharten Diamantschicht durch besondere Abscheidungsbedingungen (Veränderung der Keimzahl und Wachstumsgeschwindigkeit durch Änderung der Abscheidungstemperatur oder besondere Sättigung des Gasraumes mit den reagierenden Komponenten oder durch eine besondere Beeinflussung (Beschleunigung) der Ionen etc.) deren Eigenschaften so zu verändern, daß diese deutlich von den ursprünglich eingesetzten Kernen abweichen. Es ist ferner möglich, durch diese Verfahren auch von idealem Diamantkristall stark abweichende fehlerhafte und verzerrte Kristallgitter zu erzeugen, bis hin zu Übergangsformen, die z. B. Einschlüsse von Lonsdaleit, d. h. ausgeprägte Stapelfehler des Gitters und sogar bis hin zu Strukturen, die der Stoffgruppe der Carbine angehören oder teilweise amorphe Strukturen zeigen.

Durch verschiedene Abscheidungsbedingungen sind dabei u. a. Eigenschaftsveränderungen möglich, die die Schale von dem eingebrachten, relativ gut kristallisierten, kubischen Diamanten deutlich unterscheiden, beispielsweise:
1. Änderung der optischen Eigenschaften:
   Farbe, z.B. blau (durch B-Zusätze), gelb-durchsichtig (durch N₂) oder braun bis schwarz (durch verschiedene Reinheitsgrade oder Verunreinigungen, z. B. durch Elemente wie Ni, Fe, Mn etc.). Damit verbunden sind z. B. bestimmte: Lichtbrechung, Lichtreflexion, Lichtszintilationseigenschaften, Röntgen-, Thermo-, Elektro- und Kathodoluminiszenz, z. B. mit verschiedenen Donor- und Akzeptorzentren, die durch Doping und/oder infolge Wachstumsfehler entstehen, anormale Doppelbrechung, Photoleitfähigkeit, UV- und/oder IR-Absorption oder Fluoreszenz und Phosphoreszenz.
2. Änderung der mechanischen, thermischen, morphologischen und anderer Eigenschaften, wie z. B.:
   Dichte, Härte, Festigkeit, E-Modul, Spaltbarkeit, Abriebbeständigkeit und Abriebfestigkeit, thermische Leitfähigkeit, Bildung besonderer Kristallfacetten (z. B. ausschließlich Oktaederflächen oder Würfelflächen durch Zusätze von Mn, Zr, Platinmetalle etc. oder [113] Facetten, z. B. durch B-Zusätze, wie oft auf Ge- und Si-Kristallen beobachtet, Typ I Diamanten bzw. Ia oder Ib ähnliche Diamanten mit hohen Stickstoffgehalten oder anderen besonderen Verunreinigungen oder Typ II bzw. Typ IIa oder IIb Diamanten, z. B. durch besonders niedrige Stickstoffgehalte.
3. Änderungen von elektrischen Eigenschaften, wie:
   elektrische Leitfähigkeit, Halbleitereigenschaft vom p-Typ (z. B. durch B-, Al- oder ähnlichen Zusatz oder Zusatz von freiem Kohlenstoff) mit besonderen Druck- und Temperaturabhängigkeiten, Halbleitereigenschaften vom n-Typ z. B. durch Legieren mit Stickstoff, P, As, Sb oder Li als Zwischengitter-Donoren und anderen geeigneten Elementen.
4. Änderung chemischer Eigenschaften, z. B.:
   Benetzbarkeit durch flüssige Metalle, Legierungen etc., Benetzbarkeit durch oxidische und silicatische Schmelzen, Oberflächenreaktionsgeschwindigkeiten mit chemischen Stoffen, z. B. chemische Resistenz gegen oxidierende Medien, wie Sauerstoff, Salzschmelzen etc. oder reduzierende Medien, wie H₂, CO etc., Umwandlungskinetik (Geschwindigkeit) bei Erhitzen über 500 °C der superharten metastabilen Modifikationen in die stabilen Modifikationen.

Im Falle von superhartem Bornitrid als Schale können analoge Eigenschaftsänderungen wie oben unter Punkt 1 bis 4 erzielt werden, wobei beispielsweise durch Zusatz von je 0,01 bis 5 Atom-% und/oder Se und/oder Te, vorzugsweise durch Zusatz von 0,15 bis 0,3 Atom-% dieser Elemente, halbleitende Eigenschaften mit einer Aktivierungsenergie im Bereich von 0,01 bis 0,5 eV, vorzugsweise von 0,1 bis 0,2 eV, durch Zusatz von 0,001 bis 2 Atom-%, vorzugsweise von 0,05 bis 0,5 Atom-% Sb p-Typ-Halbleiter erhalten werden.

Manche der hier aufgelisteten Eigenschaftsänderungen können zum Teil einzeln, zum Teil gemeinsam auftreten und ermöglichen eine starke Erweiterung der Nutzbarkeit derartiger mit Diamant bzw. superhartem BN umhüllter Verbundpulver.

Alle hier genannten Änderungen der Eigenschaften der in der Schale gebildeten Diamant- bzw. BN-Schicht(en) können nicht nur bei Diamant- bzw. BN-Kernen, sondern auch bei allen anderen hier angeführten Kernmaterialien angewendet werden.

Ebenso ist es möglich, derartige modifizierte Diamantschichten oder BN-Schichten mit besonderen Eigenschaften als sogenannte "Coatings" auf größeren Verbundkörpern aufzubringen, die nicht pulverförmig sind. Das Substrat muß dabei nicht aus Diamant bestehen. Die praktische Nutzung dieser Verbundkörper kann durch die besonderen Eigenschaften der aufgebrachten Diamantcoating-Schichten auch an größeren Körpern direkt, d. h. ohne die Notwendigkeit des Verpressens von Pulvern genutzt werden und stellen daher Erweiterung der in diesen Patenten genannten Anwendungsmöglichkeiten dar.

Für die Substrate dieser Verbundkörper gelten die später beschriebenen Ausführungen bezüglich der Beschaffenheit der Kerne der Verbundteilchen.

### 3. Kombination: Verbundpulverteilchen bestehend aus wenigstens zwei chemisch verschiedenen superharten Stoffen als Kern oder Hülle (z. B. Diamantkern mit BN-Schicht oder umgekehrt).

Die Kombination verschiedener superharter Stoffe in einem Verbundpulverteilchen war bisher nicht möglich, da geeignete Verfahren zur Bildung einer Schicht fehlten. So ist z. B. die Kombination von superhartem Bornitrid und superhartem Diamant von besonderem Interesse, da die beiden superharten Stoffe sich in ihrern Polier-, Schleif- und Schneideigenschaften, z. B. gegenüber Stahl, Aluminium, Gesteinen u. a. Stoffen, wesentlich unterscheiden. Dabei ist entweder der Kern eine ein- oder polykristalline superharte Modifikation des Kohlenstoffs und die Umhüllung eine oder mehrere ein- oder polykristalline Phase(n) des superharten Bornitrids oder umgekehrt. Ebenso können hier alle anderen oben definierten Superhartstoffe mit Härten von über 3500 Vickers beliebig verwendet werden.

### 4. Kombination: Superharter Kern mit superharter polykristalliner Schicht (chemisch gleich oder verschieden) sowie Ein lagerung ihrer stabilen Phasen in den Korngrenzen.

Eine weitere Möglichkeit ist, daß insbesondere bei den polykristallinen Schichten neben den superharten und metastabilen auch die normalen stabilen Phasen gleiche chemischer Zusammensetzung in gewissen Anteilen erzeugt werden können. Beispielsweise kann eine Umhüllungsschicht aus polykristtallinem Diamant, in den Korngrenzen, je nach Herstellungsart, mehr oder weniger große Anteile von Graphit und/oder amorphem Kohlenstoff enthalten. Dies bringt beispielsweise bei jenen Anwendungen Vorteile, wo die Pulverteilchen nachträglich in einer Hochdruckpresse zu einem größeren Körper verdichtet werden. Dieser Graphitanteil hilft, vor seiner Hochdruckumwandlung in Diamant eine besonders dichte Packung des Preßkörpers zu erzeugen, da er im ersten Augenblick des Zusammenpressens zunächst ein Gleiten der Körper untereinander und eine Verschiebung in sich ermöglicht, was die optimale Verdichtung erlaubt. Da der Graphit sehr fein verteilt ist, ist er in dieser Wirkung besonders günstig und besser geeignet als die dafür normalerweise zugesetzten Graphitpulveranteile.

Aber auch bei gewissen direkten Anwendungen der Verbundpulver zum Schleifen und Polieren hat der Graphitanteil eine positive Wirkung auf die Schleif- und Polierwirkung, da er infolge seiner Gleiteigenschaften und seiner besonderen Verteilung im Verbundkörper den Vorgang der Oberflächenglättung günstig beeinflußt.

Analoge Beispiele gelten für die superharten kubischen bzw. hexagonalen Bornitridphasen und die amorphen oder die normalerweise hexagonal auftretenden weichen Schichtstrukturen des Bornitrids. Auch hier kann die gleichzeitige Erzeugung dieser Nichthartstoffphasen durch geeignete Prozeßbedingungen gesteuert werden.

### 5. Kombination: Kern mit einer oder mehreren äußeren superharten Schichten allein oder mit zusätzlichen normalen Schichten oder Hartstoffschichten.

Beispielsweise kann die Kombination von einem oder mehreren superharten Stoffen mit solchen Hartstoffen, die teilweise zum Polieren oder Schleifen heute bereits industriell genutzt werden (z. B. Aluminiumoxid, Siliciumcarbid, Borcarbid usw.), von besonderem Vorteil sein.

Dabei kann entweder nur der Kern ein normaler Hartstoff sein und ein einziger Superhartstoff die Schalen bilden, oder es können mehrere superharte Schichten aufgebracht werden, wobei als Zwischenlagen auch normale Stoffe oder Hartstoffschichten gewählt werden. In diesem Fall wird z. B. die Griffigkeit des superharten Stoffes, der in mehreren Lagen in der Schale aufgebracht wurde, durch eine Art Selbstschärfung erhöht, weil der zwar harte, aber doch vergleichsweise zum Superhartstoff relativ weiche Hartstoff schneller abgerieben wird und damit der superharte Stoff immer eine scharfe Schneidkante für die Polier- oder Schleifarbeit darbietet. Durch Aufbringen in wechselnder Folge von superharten und harten Schichten ist dieser Effekt besonders ausgeprägt. Wichtig ist hierbei, daß die jeweilige Dicke der Schichten und ihre Härte in einem optimalen Verhältnis zueinander stehen. Je dünner die superharte Schicht, umso härter muß auch die Zwischenschicht der Hartstoffe sein, damit der sonst allzu rasche Verschleiß dieser Schicht nicht zu einem Ausbrechen und Abplatzen der superharten Schicht führt.

Die mehrlagige Aufbringung von superharten Stoffen in wechselnder Folge ermöglicht aber auch eine besonders feinkörnige Unterteilung dieser nach dem Verpressen und/oder Sintern in einem größeren Verbundkörper.

Auch die besondere chemische Resistenz oder andere Oberflächeneigenschaften der superharten Werkstoffe können hierbei genutzt werden.

Beim Verpressen derartiger mehrlagiger Verbundpulver können, z. B. besonders wenn als letzte äußerste Schicht eine besonders in Bezug auf ihre chemische Beständigkeit und Benetzung ausgewählte Schicht aufgebracht wird, die üblichen Vorteile der mehrphasigen Verbundpulverteilchen, wie gute Benetzbarkeit oder gute Kaltverschweißbarkeit oder besondere Resistenz gegenüber flüssigen Phasen bei der Herstellung usw., optimal genutzt werden.

### 6. Kombination: Der Kern besteht aus einem winzigen Keim, auf dem der Superhartstoff aufgewachsen ist.

Dieser Keim kann aus einem artfremden Stoff bestehen und so klein sein, daß er praktisch nur schwer sichtbar gemacht werden kann (= heterogener Keim) oder arteigenes Material darstellen und nur aus einem sehr fehlerhaften Kristallgitter des superharten Stoffes selbst bestehen (= homogener Keim).

Im folgenden sind einige Stoffbeispiele aufgelistet, die zahlreiche weitere Kombinationen zeigen; denn der Erfindung entsprechend wird ein Verbundpulverteilchen hergestellt, bestehend aus einem in seiner Natur und seiner Größe sehr variablen inneren Kern, der von einer anhaftenden, vorzugsweise fest anhaftenden, äußeren Schale umhüllt wird. Diese besteht vollständig oder nur teilweise aus einem superharten Stoff und ist in ihren Dimensionen und in der Wahl der nicht superharten Zwischenschichten in weiten Bereichen variierbar. Derartige Zwischenschichten können im Prinzip aus dem gleichen Stoff wie die nachfolgend beschriebenen Kernmaterialien ausgewählt werden.

Der Kern ist entweder ein superharter Stoff, bestehend aus einem einkristallinen Diamant oder Lonsdaleit oder einer anderen einkristallinen superharten Kohlenstoffmodifikation, einem polykristallinen Diamant oder Lonsdaleit oder einer anderen polykristallinen Kohlenstoffmodifikation, einer einkristallinen superharten Modifikation von Bornitrid, einer polykristallinen superharten Modifikation von Bornitrid oder ein harter Stoff, der bei Temperaturen bis 1000 °C mit Kohlenstoff und/oder BN nicht oder nur langsam reagiert oder diesen nicht oder nur wenig auflöst, bestehend aus einem Karbid, z. B. SiC, B₄C, WC, TiC, TaC etc. einem Nitrid, z. B. TiN, TaN, ZrN, AlN, Si₃N₄ etc., einem Borid, z. B. TiB₂, TaB₂, WB, etc., einem Phosphid, z. B. BP etc., einem Sulfid, z. B. CaS, CeS etc., einem Silicid, z. B. MoSi₂, TiSi₂ etc., einem Oxid, Oxynitrid, Oxycarbid, Cxycarbonitrid, z. B. Al₂O₃, AlNO, AlCON, Ti(C,O), Zr(C,N.O) etc., einer NOSC (= Non-Oxide-Silicon-Ceramic) oder SiAlON etc., oder ein anorganischer Stoff normaler Härte, der bei Temperaturen bis 1000 °C mit Kohlenstoff und/oder BN nicht oder nur langsam reagiert oder diesen nicht oder nur wenig auflöst, wie z. B. Metalle wie Cu, Ag, Au etc., oder Legierungen oder eine intermetallische Phase(n) oder Verbindungen wie Oxide und Oxidgemische wie Silicate, Aluminate, Spinelle etc., oder Sulfide, Karbide, Nitride, Carbonitride, Oxykarbide, Silicide, Boride, Oxycarbonitride, Hydride, Aluminide, Ferrite etc., oder Oxidgemische oder anorganische Salze oder mehrphasige Mischungen dieser Stoffe bzw. Mischkristalle dieser Stoffe oder ein fester Stoff, der ein Reaktionsprodukt darstellt, das im Reaktionssystem spontan auftritt und als heterogener Kristallkeim wirkt.

Das Verbundpulverteilchen ist ferner charakterisiert dadurch, daß die Schale wenigstens eine Lage eines superharten Stoffes aufweist, wobei der Kern z. B. aus einer der oben aufgelisteten Substanzen besteht und wobei die äußere superharte Schale epitaxisch auf einem einkristallinen Kern aufgewachsen ist oder jede kristallographische Beziehung zwischen dem Kern und der ersten Schale fehlt, oder Übergänge zwischen den beiden Extremfällen in beliebigen Maß auftreten können oder die polykristalline Schale neben dem superharten Stoff den gleichen Stoff in seiner stabilen Modifikation enthält, welche in der Korngrenze vorkommt, wobei, wenn der superharte Stoff Diamant oder Lonsdaleit oder eine andere superharte Kohlenstoffmodifikation ist, zusätzlich entweder (Graphit und/oder amorpher Kohlenstoff auftreten, und wenn der Stoff eine superharte Modifikation von Bornitrid ist, zusätzlich entweder weiches hexagonales und/oder amorphes BN auftritt, oder die äußere Schale aus mehreren Schichten besteht, wovon mindestens eine aus kristallinem oder polykristallinem Diamant und/oder Lonsdaleit und/oder einer anderen superharten Kohlenstoffmodifikation besteht und diese eine zusammenhängende Schicht bilden, oder die äußere Schale aus mehreren Schichten besteht, wovon mindestens eine aus einkristallinen oder polykristallinen Modifikationen von superhartem Bornitrid besteht und dieses eine zusammenhängende Schicht bildet, oder die äußere Schale aus mehreren Schichten, die in regelmäßiger Reihenfolge abwechselnd immer wieder Zwischenschichten von Diamant und/oder superhartem Bornitrid enthalten, besteht, oder desgleichen, wobei in wechselnder unregelmäßiger Folge sowohl Diamantschichten als auch kubische Bornitridschichten verwendet werden, oder die äußeren Schichten neben Diamant und/oder superharten BN-Schichten und/oder anderen superharten binären oder ternären Phasen aus dem System B,N,C auch andere Schichten (z. B. die eben als Kern genannten anorganischen Stoffe) in der Schale des Verbundteilchens als Zwischenschicht enthalten.

Die Dimensionen des Verbundkörperteilchens sowie die Größe des Kernes bzw. der Umhüllung kann in weiten Grenzen variiert werden, z. B. ist der Durchmesser des inneren Kernpartikels bei gewissen Pulvern, die alle für superharte Pulver heute übliche Durchmesser erreichen können, bei bewußt gewählten Versuchsbedingungen infolge homogener Keimbildung oder aus spontan sich bildenden Reaktionsprodukten (heterogene Keime) aus der stark übersättigten Gasphase sehr viel kleiner als 0,01 µm und daher praktisch auch mit den üblichen wissenschaftlichen Methoden nur schwer nachweisbar. Weist der Durchmesser des inneren Kernpartikelchens eine Größe von 0,01 bis 100 µm, vorzugsweise jedoch zwischen 1 und 10 µm, auf, liegt der äußere Durchmesser des Pulververbundteilchens zwischen 1 µm und mehreren 1000 µm, vorzugsweise aber im Bereich zwischen 10 und 100 µm, haben die einzelnen Schichten oder äußeren zusammenhängenden Schale jeweils eine Dicke zwischen 0,1 und 5000 µm, jedoch vorzugsweise zwischen 1 und 5 µm.

Auch der Aufbau ist variabel. Es können zum Beispiel die äußeren Schichten der Schale in gewisser Reihenfolge aufgebracht werden und zueinander in einem geordneten und regelmäßigen Verhältnis stehen, die in der äußeren Schale liegenden Schichtdicken des superharten Stoffes im Bereich zwischen 1 und 5 µm liegen, wobei die Hartstoffschichtdicke nur etwa die Hälfte bis ein Zehntel dieser Dicke betragen soll, die in der Schale liegenden Schichten des superharten Stoffes zwischen 100 und 500 µm liegen und der Hartstoff etwa gleich dick wie die Superhartstoffschicht sein.

Die Verbundmaterialteilchen werden erfindungsgemäß nach einem Wirbelschichtverfahren in Verbindung mit einem Gasphasenabscheidungsverfahren hergestellt. Allerdings muß das Verfahren in dem Sinne modifiziert werden, daß der Gasstrom, der die Pulverteilchen in Wirbelschichtbewegung hält, durch eine geeignete Vorbehandlung einen reaktiven und angeregten Gasanteil enthält, der die Entstehung der weichen und im Druck- und Temperaturbereich des Verfahrens thermodynamisch stabilen Phasen anstelle der metastabilen superharten Phasen verhindert. Insbesondere ist z. B. bei der Herstellung von Diamant, ein entsprechend hoher Anteil eines reaktiven atomaren Wasserstoffatomes im Gas, sowie die Bildung von Kohlenstoffradikalen bzw. entsprechender Ionen von Bedeutung, da sonst weder der Diamant entsteht, noch die Bildung von unerwünschtem weichem Graphit oder von Kohlenstoffphasen verhindert bzw. kontrolliert werden kann.

Ähnliches gilt für die Herstellung der superharten Bornitridphasen. Durch eine geeignete Gasanregung müssen die Bor enthaltenden Gasmoleküle und/oder ein zweites Gas, wie z. B. Wasserstoff, Halogene oder Gemische daraus, in einen solchen Zustand gebracht werden, daß die Bildung der weichen hexagonalen Bornitridphase oder amorpher Phasen unterdrückt oder kontrolliert werden kann und die superharten Phasen als Hauptbestandteile oder ausschließlich abgeschieden werden.

Die oben erwähnte Anregung und Herstellung entsprechen aggressiver Gase (H₂, Halogenide etc.) bzw. die Modifikation der Bor- bzw. Kohlenstoffverbindungen gelingt durch die Verwendung von Verfahren, die die gasförmigen Moleküle oder Atome entsprechend aufbricht und kurzlebige Ionen, Radikale oder atomare Gasspezien erzeugt. Dies kann auf verschiedene Art geschehen, beispielweise durch Erhitzen z. B. mit Hilfe einer glühenden Metalloberfläche, z. B. eines Ta- oder W-Drahtes, -Rohres oder -Netzes mit entsprechend hoher Temperatur, durch Gasentladungen im Unterdruck, ausgelöst von Gleich- oder Wechselströmen, durch die Anwendung eines kalten Plasmas, hergestellt durch elektromagnetische Wellen vorzugsweise im Mega- und Gigahertz-Bereich, durch Ultraschall bzw. Druckwechsel, durch die Verwendung rein chemischer Verfahren, wie z. B. durch Zersetzung von HJ oder HBr mit Licht, wobei die Bildung von atomarem Wasserstoff und Halogenen erzwungen wird. Werden dabei Stoffe verwendet, die als Endprodukt eine bei Reaktionstemperatur feste oder flüssige Phase bilden, so können diese als Kerne (heterogene Keime) des superharten Stoffes auftreten.

Derartige Anregungsverfahren sind zum Teil in den oben genannten Patenten enthalten und zum Teil auch in der älteren Literatur bereits erwähnt.

Es eignen sich insbesondere jene CVD-Verfahren zum Beispiel als Wirbelschichtverfahren oder CVD-Verfahren mit up-stream-Reaktoren, bei denen dieser Anregungszustand der Gase, bevor diese die Partikel z. B. in der Wirbelschicht erreichen, nicht zu stark verlorengeht und außerdem die in den Normalzustand zurückgekehrten Gasmoleküle, nach ihrer Reaktion oder auch unverbraucht, möglichst geringe Konzentrationen in der Wirbelschicht erreichen. Das heißt, sie müssen aus dieser so rasch wieder entfernt werden, daß sie den Ablauf der gewünschten Reaktion nicht stören. Die Wirbelbettkonstruktion muß daher in Bezug auf die Verweilzeit der Gase den Bedürfnissen und der Kinetik der Abscheidungsreaktionen möglichst optimal angepaßt werden.

Im erfindungsgemäßen Verfahren verwendet man
einen Gasstrom bestehend aus CH₄ oder einer anderen gasförmigen oder dampfförmigen Kohlenstoffverbindung sowie atomarem und molekularem Wasserstoff, sowie entsprechenden Ionen und Radikalen, die aus den Ausgangskomponenten entstehen können,
einen Gasstrom bestehend aus einer gas- oder dampfförmigen Borverbindung bzw. festen bzw. flüssigen Borverbindungen (z. B. Borhalogenide, Borane, Borazine, Bor-Mg-, Bor-Al-Verbindugnen), die solche bleiben können - mit oder ohne atomarem und molekularem Wasserstoff - und atomarem und molekularem Stickstoff, sowie entsprechenden Ionen und Radikalen, die aus den Ausgangskomponenten entstehen können,
einen Gasstrom bestehend aus einer gas- oder dampfförmigen Borverbindung (z. B. Borhalogenide, Borane, Borazine, Bor-Mg-, Bor-Al-Verbindungen etc.) - mit oder ohne atomarem und molekularem Wasserstoff - sowie atomarem und molekularem Stickstoff und/oder atomarem und molekularem Halogen oder Verbindungen dieser Stoffe, sowie Ionen und Radikalen, die aus den Ausgangskomponenten entstehen können, oder
einen Gasstrom, der eine gas- oder dampfförmige Verbindung enthält, die neben anderen Atomen Bor- und Stickstoffatome als wesentliche Bestandteile aufweist, die bei starkem Erhitzen in BN zerfällt, und deren Gas oder Dampf in Verbindung mit anderen atomaren oder molekularen Gasen, wie Wasserstoff und/oder Stickstoff und/oder Halogen und/oder Edelgasen bzw. Verbindungen dieser Stoffe, Ionen, Radikale, atomare Spezien, die aus den Ausgangskomponenten dieser Mischung entstehen können, enthält.

Wenn in der Beschreibung oder den Ansprüchen von gas- oder dampfförmigen Kohlenstoffverbindungen die Rede ist, so sind damit organische Kohlenstoffverbindungen mit Wasserstoff und/oder Sauerstoff und/oder Stickstof und/oder Schwefel und/oder Phosphor gemeint.

Das Verfahren arbeitet vorzugsweise im Bereich von 66,65 Pa bis 6,665 kPa (zwischen 0,5 und 50 Torr) im diskontinuierlichen oder kontinuierlichen Betrieb.

Eine spezielle Anwendung der nach dem erfindungsgemäßen Verfahren erhaltenen Verbundmaterialteilchen ist folgende: Zur Erzielung eines Pulvers des superharten Materials der Schale, wie Diamant- oder Bornitridpulver, werden die Kerne des Verbundpulvers selektiv durch eine chemische Ätzung, gegebenenfalls nach Zerstoßen, aufgelöst, so daß das abgeschiedene superharte Material als Pulver zurückbleibt.

Es gibt zahllose Möglichkeiten, für die hier beschriebenen Kerne Substanzen auszuwählen, die sich chemisch wesentlich leichter auflösen als die superharten Stoffe, die auf ihnen abgeschieden wurden.

Superharte Diamantpulver, die auf diese Art und Weise gewonnen werden, könnten sich von normalen Natur- oder Hochdruck-Diamantpulvern folgendermaßen unterscheiden:
a) durch eine in diesem Diamantpulver - im Vergleich zu Hochdruck- oder Naturdiamanten - vorhandene, stark erhöhte Zahl der Gitterfehler;
b) aufgrund besonderer Kristallhabitusflächen, die nur oder vermehrt bei den plasmaabgeschiedenen Pulvern entstehen und bei Naturdiamanten und Hochdruckdiamanten nicht oder nur in seltenen Fällen austreten;
   beispielsweise sind in diesen Pulvern gewisse Anteile von Partikeln vorhanden, die einen fünfersymmetrischen Aufbau erkennen lassen und/oder kubische Oktaeder und/oder kubische Oktaeder mit einer Zwillingsebene und/oder Wulff-Polyeder und/oder Pencagondodekaeder und/oder diverse Zwillingsverwachsungen obiger Kristallmorphologien, darstellen;
c) durch unabsichtlich, verfahrensbedingt eingebrachte Dopingelemente, z. B. geringer Wasserstoffgehalte (größer als 0,001 % und deutlich kleiner als 10 %, vorzugsweise zwischen 0,01 und 5 %, insbesondere 0,5 bis 3 %) zumindest nach der Herstellung (d. h. ohne eine besondere Vakuum- und Wärmebehandlung);
d) durch absichtlich eingebrachte Dopingelemente (siehe Liste der Verunreinigungen in der obigen Beschreibung);
e) durch eine gegenüber dem Hochdruckdiamanten erniedrigte Aktivierungsenergie für die elektrische Leitfähigkeit, z. B. bei B-Zusatz im Diamanten von 0,013 eV gegenüber 0,15 bis 0,3 eV bei Hochdruckdiamant;
f) durch ein von Naturdiamant verschiedenes, an C¹³ angereichertes Isotopenverhältnis von C¹²/C¹³.

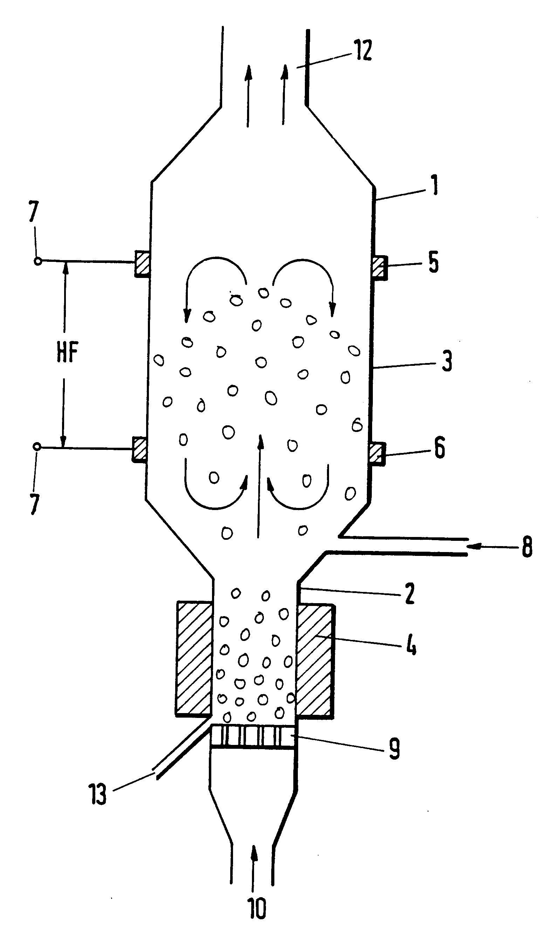

Die beigefügte Zeichnung zeigt beispielhalber in schematischer Darstellung eine Vorrichtung zur Durchführung eines Verfahrens zur Herstellung erfindungsgemäßer Verbundmaterialteilchen.

Die in der Zeichnung dargestellte Vorrichtung besteht aus einem Reaktor 1 mit einem Vorheizabschnitt 2 und einem Reaktionsraum 3. Der Vorheizabschnitt 2 ist von einem Heizofen 4 umgeben und ist als Rohr ausgebildet, das sich zum Reaktionsabschnitt 3 hin erweitert. Das untere Ende des Vorheizabschnittes 2 bildet eine gasdurchlässige, für die eingefüllten Teilchen aber undurchlässige Verteilerplatte 9, wie eine Frittenplatte. Im Vorheizabschnitt 2 befindet sich ein feines Pulver (Kerne). Es kann zusätzlich ein gröberes neutrales Pulver eingeführt werden, das vornehmlich zur Wärmeübertragung dient und so grob ist, daß es nicht aus dem Raum 2 in den Raum 3 ausgeblasen wird.

In den unteren Bereich des Reaktionsabschnittes 3 mündet ein Zufuhrrohr für die Einführung von Kohlenstoffverbindungen, Borverbindungen oder anderer Reaktionsgase, während am unteren Ende des Reaktors 1 unterhalb der Verteilerplatte 9 eine Einrichtung zum Einführen von gewärmtem Reaktionsgas (z. B. Wasserstoffgas) mit oder ohne Zusatz eines Trägergases, wie z. B. Helium oder Argon, vorgesehen ist.

Der Reaktionsabschnitt 3 ist von zwei Wicklungen 5 und 6 umgeben, an die bei 7 eine Hochfrequenzspannung angelegt ist und durch die in dem Reaktionsabschnitt ein kaltes Gasplasma angeregt wird.

Das obere Ende des Reaktionsabschnittes 3 wird von einem Gasabzug gebildet, durch welchen auch die zu beschichtenden Teilchen eingefüllt werden. Am unteren Ende des Vorheizabschnittes 2 befindet sich eine während der Reaktion geschlossene Einrichtung 13 zum intermittierenden Ablassen fertiger beschichteter Verbundmaterialteilchen.

Die in der Figur dargestellte Vorrichtung arbeitet im Falle der Diamantsynthese wie folgt:
Durch das obere Ende 12 des Reaktors 1 wird das als Kerne dienende Pulver eingefüllt und fällt in den Vorheizabschnitt 2 auf die Verteilerplatte 9. Nunmehr wird durch den Einlaß 10 vorgewärmtes Wasserstoffgas allein oder im Gemisch mit Helium (Trägergas) in solcher Menge eingeführt, daß sich über der Verteilerplatte 9 in dem Vorheizabschnitt 2 eine dachte Wirbelschicht von Teilchen bildet. Diese wird durch den Ofen 4 geheizt.

Aus dem Vorheizabschnitt gelangen Pulverteilchen durch das aufwärts strömende Gas in den erweiterten Reaktionsabschnitt 3, wo sie in der Mitte des Gasraumes auswärts strömen. Infolge der im Reaktionsabschnitt 3 herrschenden geringen Gasgeschwindigkeit fallen die mitgerissenen Teilchen im äußeren Raum des Reaktionsabschnittes 3 wieder nach unten. Durch die angelegte Hochfrequenzspannung und das dadurch erzeugte Feld wird ein Plasma angeregt. Gleichzeitig wird unter Umgehung des Vorheizabschnittes durch den Einlaß 8 eine gas- oder dampfförmige Kohlenstoffverbindung eingeführt. Diese Kohlenstoffverbindungen werden von dem Trägergas/Wasserstoffgas-Strom in den Reaktionsabschnitt mitgerissen und mischen sich in diesem, wobei in dem angeregten Plasma die Beschichtungsreaktionen sich abspielen. Die an der Quelle 7 angelegte Hochfrequenzspannung beträgt beispielsweise 80 MHz.

Die in dem Reaktionsabschnitt 3 beschichteten Teilchen fallen in den Vorheizabschnitt 2 und die dort befindliche dichte Wirbelschicht zurück. Zu erwähnen ist, daß die Teilchendichte der Wirbelschicht im Reaktionsabschnitt 3 erheblich geringer ist als die Teilchendichte in der Wirbelschicht des Vorheizabschnittes 2.

Die Reaktionsgase und das Trägergas verlassen im Gemisch miteinander den Reaktor 1 durch das obere Ende 12.

Die in der Zeichnung dargestellte Vorrichtung arbeitet ansatzweise. Wenn auf den Teilchen eine ausreichend dicke Schicht als Schale abgelagert ist, wird der Gasstrom durch den Einlaß 10 und den Einlaß 8 unterbrochen, und die fertigen Verbundmaterialteilchen werden durch den Auslaß 13 aus der Vorheizzone abgezogen.

Ein besonderer Vorteil dieser Anordnung besteht darin, daß die verbrauchten Gase nur kurzzeitig mit den Teilchen in Berührung stehen und rasch aus dem Reaktionsabschnitt entfernt werden, da, um diese sogenannte pneumatische Wirbelschicht aufrechtzuerhalten, eine hohe Gasströmungsgeschwindigkeit erforderlich ist.

Die Vorrichtung kann selbstverständlich auch kontinuierlich ausgebildet werden. Hierzu wird auf das obere Ende 12 des Reaktors ein Zyklon aufgesetzt, der mitgerissene Teilchen von den verbrauchten Gasen abtrennt und über eine nicht gezeigte Rezyklierleitung zum unteren Bereich des Reaktionsabschnittes 3 zurückführt. Auch der Teilchenabzug durch den Austritt 13 kann dann kontinuierlich vorgenommen werden. Selbstverständlich können vorteilhaft auch mehrere derartige Anlagen in Reihe hintereinandergeschaltet werden, die nacheinander unterschiedliche oder gleiche Schichten auf dem Kern aufbringen. Es wird dadurch auch möglich, die mit der Vergröberung der Teilchen einhergehende Erhöhung der Sinkgeschwindigkeit bei gleichbleibender Gasströmungsgeschwindigkeit zu kompensieren. Die Trennung der größeren von den kleineren Teilchen erfolgt im Zyklon. Nur der Feinanteil geht in dem ersten Beschichtungsreaktor zurück, während die gröbere Fraktion in einem zweiten Reaktor mit anderen Strömungsgeschwindigkeiten weiter vergröbert wird. Damit kann jede Kornfraktion optimal beschichtet werden.

### Beispiel 1a

### Versuchsbedingungen

100 g Diamantpulver, 0,5 µm mittlerer Korndurchmesser, gut kritallisiert, Wasserstoff mit 0,5 % Methan.

| | |
|---|---|
| Gasdurchflußgeschwindigkeit: | 20 cm³/min |
| Temperatur des Ta-Glühfadennetzes: | 2100 °C |
| Temperatur des Wirbelbettes: | 750 °C |
| Gasdruck: | 2,65 kPa (20 Torr) |
| Reaktionszeit: | 20 h |

Unterstützung des Wirbelbettes mit 50 % Fremdgas-Zusatz (entfällt bei Beispiel 1c und 1e), wodurch ca. 50 cm³/min Gasfluß entsteht.

### Versuchsdurchführung

Beschicken der Wirbelschicht-Apparatur mit Diamantpulver Aufheizen des Wirbelbettes unter Wasserstoff, anschließend kurze Ätzperiode (10 min) mit reinem H₂ unter zeitweiser Zuhilfenahme eines glühenden Wolframdrahtnetzsystems anschließend Zumischen von Methan 0,5 %
Versuchsdauer 20 h.

### Resultat

Einkristalline Umhüllung gewachsen auf die ursprünglichen 0,5 µm Körner bis auf einen Durchmesserbereich zwischen 10 und 20 µm, mittlerer Kornbereich 16 µm.

### Beispiel 1b

Dem Gas wurde zusätzlich 0,01 % Borwasserstoff zugesetzt. Das Resultat ist weitgehend identisch. Außenhülle des aufgetragenen Diamantpulvers ist mit Bor gedopt und hat entsprechende elektrische Eigenschaften.

### Beispiel 1c

Durchflußmenge auf 200 cm³/min und die CH₄-Konzentration auf 2 % erhöht.

Resultat: Polykristalline Schichten wachsen anstelle von einkristallinen Schichten. Schichtdicke auf das ca. 3- bis 4fache erhöht.

### Beispiel 1d

Anstelle der einkristallinen 0,5 µm-Pulverteilchen als Einsatzmaterial wurden polykristalline Ballas-Diamanten verwendet. Ausgangskorngröße 5 µm.

Die höhere Gasgeschwindigkeit und die höhere CH₄-Konzentration von Beispiel 1c wird verwendet.

Resultat: Es entsteht eine polykristalline Diamantschicht mit besonderen Eigenschaften und einer Vergrößerung der Ballas (Carbonados)-Diamanten-Durchmesser um durchschnittlich 20 µm in der Versuchszeit von 20 h.

### Beispiel 1e

Ausgangsmaterial Ballas-Diamant, alle Versuchsbedingungen gleich, jedoch weitere Erhöhung des Methan-Gethaltes auf 3 % unter leichter Drosselung der Anregung der Temperatur des Ta-Drahtes auf 2000 °C.

Resultat: Ballas-Diamanten, umhüllt mit polykristalliner Diamantschicht mit ca. 10 bis 20 % zwischengelagerter Graphit und amorphem Kohlenstoff in den Korngrenzen und an der äußeren Oberfläche der gewachsenen Diamanten.

### Beispiel 2

Identische Versuchsbedingungen wie bei den Beispielen 1a bis 1c, jedoch als Kernmaterial wird SiAlON anstelle von Diamant verwendet. Korngröße 20 µm.

### Beispiel 3

Verwendung von kub. Bornitrid als Kern anstelle von Diamant, sonst analog den Beispielen 1a bis 1e.

### Beispiel 4

Herstellung eines mehrlagigen Superhartstoff-Verbundkörpers. Versuchsbedingungen: zunächst von Beispiel 2a.

Anschließend wird umgeschaltet auf eine andere Anregungsquelle mit Mikrowellen 4,8 GHz. Es werden neue Gase, bestehend aus 1 % Boran, 2 % Ammoniak, Rest Wasserstoff und geringen Zusätzen von Fluor eingebracht. Während 5 h wird superhartes Bornitrid abgeschieden.

Anschließend wird wieder rückgeschaltet auf die für Diamant nötigen Gase und abschließend durch 2 % Si₂H₆ mit 2 % Ammoniak und Rest H₂ ohne besondere Anregung der Gase die Bildung einer Si₃N₄-Schicht erzielt.

Resultat: Wechselnde Schichtstruktur.
Kern: eingebrachtes SiAlON, darauf aufgebrachte Schichten aus Diamant, Bornitrid und als äußerste Schicht Silicumnitrid. Schichtdicken in Funktion der Zeit unterschiedlich einstellbar, im vorliegenden Fall - wo bei jeweils 10 h pro Schicht beschichtet wurde - beträgt die Schichtdicke unter den gewählten Versuchsbedingungen für Diamant 4 µm, für Bornitrid 8 µm und für Siliciumnitrid 6 µm.

## Patentansprüche

1. Verfahren zur Herstellung von Verbundmaterialteilchen, bestehend aus einem inneren Kern, der von einer daran anhaftenden Schale umhüllt wird, **dadurch gekennzeichnet**, daß die Kerne in einem chemischen Gasphasenabscheidungsverfahren (CVD-Verfahren) mit Hilfe eines Gasstromes in Bewegung gehalten, bei einer Temperatur zwischen 500 und 1200 °C und einem Druck unter 66,65 kPa (500 Torr) beschichtet werden, wobei der Gasstrom aus CH₄ oder einer anderen gas- oder dampfförmigen Kohlenstoffverbindung und Wasserstoff mit oder ohne Zusatz von Edelgasen und/oder aus einer gas- oder dampfförmigen Borverbindung oder einer Bor und Stickstoff enthaltenden Verbindung und/oder Wasserstoff und/oder Stickstoff und/oder Halogen und/oder deren Verbindungen mit oder ohne Edelgaszusatz besteht, und in diesen Fällen wenigstens eines der Gase durch ein physikalisches oder chemisches Verfahren in einen angeregten Zustand gebracht wurde und das Gasgemisch in einem CVD-Reaktor, der kleine Festkörper in Schwebe hält, mit einem die inneren Kerne bildenden pulverförmigen Substrat in Kontakt gebracht wird.

2. Verfahren nach Anspruch 1, **dadurch gekennzeichnet**, daß der Gastrom durch
a) eine stark erhitzte glühende Oberfläche eines festen Stoffes, vorzugsweise eine Metalloberfläche aus Tantal oder Wolfram, und/oder
b) eine Gasentladung im Unterdruck, ausgelöst von Gleich- oder Wechselstrom, und/oder
c) ein Plasma, hergestellt durch elektromagnetische Wellen, vorzugsweise im Giga- und Megahertz-Bereich, und/oder
d) Ultraschall bzw. Druckwechsel und/oder
e) ein chemisches Verfahren unter Zersetzen mit Licht oder durch chemische Reaktion
angeregt wird, wobei in allen angeführten Fällen wenigstens eines der eingesetzten Gase vor oder während der Berührung mit dem zu umhüllenden Kern teilweise in einen angeregten Zustand versetzt wird und kurzlebige und sich spontan in beständigere Stoffe umwandelnde Radikale und/oder atomare Spezien der eingesetzten Gase und/oder von Verbindungen, die sich aus dsen Gasgemischen bilden können, gebildet werden.

3. Verfahren nach Anspruch 1 oder 2, **dadurch gekennzeichnet**, daß man die äußere Schale aus mehreren Schichten aufbaut, wovon mindestens eine aus ein- oder polykristallinem Diamant und/oder einer anderen Kohlenstoffmodifikation mit einer Härte von mehr als 3500 Vickers oder einer Modifikation von Bornitrid mit einer Härte von mehr als 3500 Vickers besteht, wobei dieser superharte Stoff eine zusammenhängende anhaftende Schicht bildet.

4. Verfahren nach einem der Ansprüche 1 bis 3, **dadurch gekennzeichnet**, daß man so kleine Kerne verwendet, daß sie als heterogene Keime für die Kristallisation des Superhartstoffes aus der damit übersättigten Gasphase anzusehen sind.

5. Verwendung von nach dem Verfahren nach einem der Ansprüche 1 bis 4 hergestellten Verbundmaterialteilchen zur Herstellung von Sinterkörpern.

## Claims

1. A process for producing particles of a composite material, consisting of an inner core which is covered by a shell which adheres thereto, **characterised in that** the cores are kept moving in a chemical gas phase separation process (CVD-process) by means of a gas flow, and are coated at a temperature of between 500 and 1200°C and a pressure of below 66.65 kPa (500 Torr), wherein the gas flow consists of CH₄ or another gaseous or vaporous carbon compound and hydrogen with or without the addition of noble gases and/or consisting of a gaseous or vaporous boron compound or a compound containing boron and nitrogen and/or hydrogen and/or nitrogen and/or halogen and/or compounds thereof with or without the addition of noble gas, and in these cases at least one of the gases has been brought into an activated state by a physical or chemical process, and the gas mixture in a CVD-reactor which holds small solid bodies in suspension is contacted with a powdery substrate which forms the inner cores.

2. A process according to Claim 1, **characterised in that** the gas flow is activated by
a) a greatly heated glowing surface of a solid material, preferably a metal surface consisting of tantalum or tungsten, and/or
b) a gas discharge at reduced pressure, given off by a continuous current or alternating current, and/or
c) a plasma, produced by electromagnetic waves, preferably in the GHz or MHz range and/or
d) ultrasound or pressure change and/or
e) a chemical process with destruction by light or by chemical reaction,
wherein in all the instances listed, at least one of the gases used is partially brought into an activated condition before or during contacting with the core which is to be covered, and short-lived radicals and radicals which are converted spontaneously into more resistant materials and/or atomic species of the gases used and/or compounds which can form from these gas mixtures are formed.

3. A process according to Claim 1 or Claim 2, **characterised in that** the outer shell is composed of a plurality of layers, at least one of which consists of mono-or polycrystalline adamantine and/or a different carbon modification with a hardness of more than 3500 Vickers or a modification of boron nitride with a hardness of more than 3500 Vickers, wherein this super hard material forms a cohesive adhering layer.

4. A process according to one of Claims 1 to 3, **characterised in that** the cores used are small enough to be considered as heterogeneous nuclei for the crystallisation of the super hard material from the gas phase which is supersaturated with it.

5. Use of particles of a composite material produced by way of the process according to one of Claims 1 to 4 for the production of sintered bodies.

## Revendications

1. Procédé de préparation de particules d'une matière composite consistant en un noyau intérieur qui est entouré d'une peau ou enveloppe adhérant au noyau, caractérisé en ce que les noyaux sont maintenus en mouvement, dans un procédé chimique de dépôt en phase gazeuse (procédé CVD) à l'aide d'un courant gazeux, ces noyaux sont revêtus à une température comprise entre 500 et 1200°C et sous une pression inférieure à 66,65 kPa (500 torr), le courant gazeux consistant en CH₄ ou en un autre composé du carbone, gazeux ou sous forme de vapeur et en hydrogène avec ou sans addition de gaz rares et/ou en un composé du bore gazeux ou sous forme de vapeur ou en un composé contenant du bore et de l'azote et/ou en hydrogène et/ou azote et/ou un halogène et/ou leurs composés avec ou sans addition de gaz rares et, dans ces cas, au moins l'un des gaz a été porté par un processus physique ou chimique à un état d'excitation et le mélange gazeux est mis en contact, dans un réacteur pour CVD, qui contient de petits corps solides en suspension, avec un substrat pulvérulent formant les noyaux internes.

2. Procédé selon là revendication 1, caractérisé en ce que le courant gazeux est excité par :
a) une surface incandescente, fortement chauffée d'un corps solide, avantageusement une surface de métal en tantale ou en tungstène, et/ou
b) une décharge dans du gaz sous dépression, déclenché par un courant continu ou alternatif, et/ou
c) un plasma produit par des ondes électromagnétiques, se situant avantageusement dans le domaine des gigahertz et des mégahertz, et/ou
d) des ultra-sons ou des variations de pression, et/ou
e) un procédé chimique avec décomposition à l'aide de la lumière ou par une réaction chimique,
et, dans tous les cas indiqués, au moins l'un des gaz introduits est ajouté, avant ou pendant la mise en contact avec le noyau à enrober partiellement en un état excité et sont formés des radicaux de courte durée de vie et se transformant spontanément en des substances plus stables et/ou des espèces atomiques des gaz introduits et/ou des composés qui peuvent se former à partir des mélanges gazeux.

3. Procédé selon la revendication 1 ou 2, caractérisé en ce qu'on forme la peau ou enveloppe extérieure en plusieurs couches dont l'une au moins consiste en diamant monocristallin ou polycristallin et/ou en une autre variante de carbone ayant une dureté supérieure à 3500 Vickers ou en une variante de nitrure de bore ayant une dureté supérieure à 3500 unités Vickers, cette matière superdure formant une couche adhérente et cohérente.

4. Procédé selon l'une des revendications 1 à 3, caractérisé en ce qu'on utilise des noyaux si petits qu'ils sont à considérer comme des germes hétérogènes pour la cristallisation de la matière superdure à partir de la phase gazeuse sursaturée en cette matière.

5. Utilisation de particules d'une matière composite, produites selon l'une des revendications 1 à 4, pour produire des corps frittés.
